# EUROPEAN PATENT APPLICATION

(11) **EP 4 730 939 A1**
(43) Date of publication of application: **22.04.2026**
(21) Application number: 25205355.8
(22) Date of filing: 29.09.2025
(51) Int. Cl.: H05K 7/20

(54) **EFFICIENT SERVER COOLING**

(30) Priority: 09.10.2024 GB 202414857
(71) Applicant: Vodafone Group Services Limited, Newbury RG14 2FN (GB)
(72) Inventor: LAW, Alan, London, W2 6BY (GB); SURENDRAN, Theivendran, London, W2 6BY (GB); SOLANKY, Devang, London, W2 6BY (GB)
(74) Representative: Boult Wade Tennant LLP

(57) **Abstract**

Server enclosure comprising a housing having an interior portion configured to receive one or more server components. A fluid circulator configured to thermally couple to the one or more server components. A first heat exchanger thermally coupled to the fluid circulator and configured to be thermally coupled to a second heat exchanger of a second server enclosure.

## Description

### Field of the Invention

The present invention relates to a system for efficiently cooling rack-mounted servers, and especially radio access network (RAN) servers and edge deployment servers, when located at base station sites.

### Background of the Invention

Many types of electrical component generate heat during operation. In particular, electrical computer components such as motherboards, central processing units (CPUs) and memory modules may dissipate substantial amounts of heat when in use. Heating of the electrical components to high temperatures can cause damage, affect performance or cause a safety hazard. Accordingly, substantial efforts have been undertaken to find efficient, high performance systems for cooling electrical components effectively and safely.

One type of cooling system uses liquid cooling. Although different liquid cooling assemblies have been demonstrated, including electrical components that are immersed in a coolant liquid so as to provide a large surface area for heat exchange between the heat generating electrical components and the coolant.

Liquid cooled servers in data centres are typically plumbed together so that they may receive liquid coolant. A server or computer enclosure, such as a housing for computing equipment forms part of a rack of similar enclosures. Typically, a rack will be formed from separate liquid-cooled server enclosures. Each separate enclosure may receive cooled fluid from a central cooling system and warmed fluid will exit each enclosure to be cooled and recirculated. This system works well in large data centres with lots of space, access to plentiful power, and large central fluid cooling systems where heat can be transferred efficiently.

Computing equipment in base station installations may also require cooling. This can be essential where edge servers are deployed at the base station, where they provide low latency processing and reduced network traffic. However, such installations may be fully enclosed and so unsuitable for data centre cooling systems or power supplies, which can lead to inefficiencies or the need to throttle back edge servers to reduce their heat output. This can also lead to server degradation and low component life spans.

Therefore, there is required a system that overcomes these problems.

### Summary of the Invention

A server or computer enclosure, such as a housing for computing or other electronic equipment that may form part of a rack of similar enclosures, is provided. The enclosure operates to improve the cooling of computing equipment when operating in close proximity to other similar enclosures. Typically, a rack will be formed of separate server enclosures that may be liquid-cooled. Rather than being connected to a central cooling system (i.e., for multiple enclosures), each enclosure can have a self-contained cooling fluid circulating circuit, where the fluid remains wholly within the enclosure. Therefore, cooling fluid does not need to leave and re-enter the housing. A heat exchanger is thermally coupled to the internal cooling fluid circuit. The heat exchanger may be formed from the housing of the enclosure or may be a separate component. When two such server enclosures are coupled together or in close proximity (e.g., on separate shelves of a rack), the heat exchanger portion or component of one server enclosure is thermally coupled to a neighbouring server enclosure (which in turn is thermally coupled to the cooling fluid circuit within that neighbouring server enclosure). Therefore, heat may flow from whichever of the neighbouring server enclosure is hotter than the other (i.e., in accordance with the second law of thermodynamics).

In this environment (an edge server within a base station installation), it is at least fairly likely that one server will be working harder (and hotter) than its neighbours. Therefore, heat can flow from hotter to cooler enclosures, effectively cooling the hotter servers, at least for short periods of time. This cooling effect may allow servers to operate for longer at higher power than if no balancing of heat output was being implemented.

In accordance with a first aspect there is provided a server or computer enclosure comprising:
a housing having an interior portion configured to receive one or more server components;
a fluid circulator configured to thermally couple to the one or more server components; and
a first heat exchanger thermally coupled to the fluid circulator and configured to be thermally coupled to a second heat exchanger of a second server enclosure. Therefore, heat generated by components of the server under a higher load (e.g., a CPU and/or GPU) may be absorbed or taken away by a server enclosure housing a server under lower or no load, which may be at a lower temperature. This can be achieved without external cooling (e.g., from an external fluid cooling circuit) resulting in fewer components, lower electrical requirements and smaller space requirements, whilst still providing sufficient cooling capacity to maintain the hotter server's processing load. The fluid circulator may be a circuit of pipes containing a freon (or other dielectric fluid), water, oil, antifreeze, or other fluid. Heat conduction pads may form a heat conduction path between the pipe or tubes and components that produce heat. Alternatively, at least portions of the interior of the server enclosure may be flooded with coolant fluid (e.g., dielectric fluid) directly over server or computer components, with the fluid being pumped around the enclosure.

Optionally, the server enclosure may further comprise:
a third heat exchanger thermally coupled to the fluid circulator and configured to be thermally coupled to a fourth heat exchanger of a third server enclosure. Therefore, a stack of more than two server enclosures can be provided with lower load servers (and their enclosures) providing cooling capacity for higher load servers in the stack or series of server enclosures. At any time, the lower load servers may become higher load servers with heat flowing in a different direction.

Preferably, the first heat exchanger and the third heat exchanger may be located on opposite sides of the housing. Therefore, heat can flow in either direction depending on which server is generating more heat. Furthermore, heat may flow through several server enclosures to further balance heat load.

Optionally, the first and/or second (and/or third) heat exchanger may further comprise a resilient member. The heat exchangers may be simple couplings providing a conforming surface between the outer surfaces of two adjacent server enclosures. Therefore, heat may flow from the fluid circulator or cooling circuit of a hotter server, through the housing (e.g., a metal housing), through the resilient member, and into the housing of a cooler server and on to the fluid circulator or cooling circuit of the cooler server. In any pair of server enclosures, there may be a resilient member of each server enclosure in contact with a resilient member of the other server enclosure or there may be a single resilient member between each pair of server enclosures.

Preferably, the resilient member may be formed of silicone rubber. Other materials may be used.

Preferably, the fluid circulator (of each server enclosure) may be configured to circulate fluid only within the housing. Therefore, the liquid circulating within each server enclosure does not need complex couplings with external pipes and the fluid is less likely to leak. Furthermore, coolers external to the server enclosure or rack of server enclosures are not required.

Optionally, the server enclosure may further comprise a heat sink or radiator located on a surface of the housing perpendicular to the first heat exchanger. This is an optional feature but could also improve heat dissipation leading to more efficient cooling. Heat can flow between adjacent server enclosures and heat can also be dissipated perpendicular to this flow, e.g., at the back of server enclosures.

Preferably, the heat sink may be thermally coupled to the fluid circulator. This can be via the housing (e.g., metal housing) of the server enclosure or more directly with the heatsink passing through the housing and abutting the fluid circulator.

Optionally, the server enclosure may further comprise a fan configured to drive air from the interior portion of the housing to the outside of the housing. This can further improve the cooling efficiency of the system.

Optionally, the one or more server components form at least a part of a radio access network (RAN) edge server. The server enclosure may be used with other servers, computing equipment or electronic components.

Preferably, the fluid circulator may further comprise a pump configured to circulate fluid. Pipes of the fluid circulator may be in fluid communication with the pump, but a gravity-fed system may also be used.

Optionally, the server enclosure may further comprise a heater within the fluid circulator. The server enclosures may be used in reverse to raise the temperature of cooler servers. This can help bring servers to a more effective operating temperature quicker, e.g., in cold or winter environments. The heater may be used to achieve this when there isn't a neighbouring hotter server.

In accordance with a second aspect, there is provided a system comprising:
a rack configured to support a first server enclosure and a second server enclosure, as described above, wherein the rack may be further configured to locate the first heat exchanger of the first server enclosure abutting the second heat exchanger of the second server enclosure. The rack or shelving system may be configured to ensure good thermal coupling between server enclosures. Preferably, the rack can support a plurality of server enclosures of similar or the same dimensions (e.g., standardised 19 inches (482.6 mm) wide server enclosures). The rack may include suitable rails so support each server enclosure.

Preferably, the system may be a base station of a telecommunications network. Other types of installations may be used (e.g., within a data centre to reduce the use of external cooling systems).

Preferably, the fluid circulator of the first server enclosure may form a separate fluid circuit to the fluid circulator of the second server. Therefore, no complex fluid couplings may be required between server enclosures. However, in some example implementations the heat exchangers may include some form of fluid transfer system between server enclosures.

The computer system of the server may include a processor or processors (e.g., local, virtual or cloud-based) such as a Central Processing Unit (CPU), and/or a single or a collection of Graphics Processing Units (GPUs). The processor may execute logic in the form of a software program. The computer system may include a memory including volatile and non-volatile storage medium. A computer-readable medium (CRM) may be included to store the logic or program instructions. For example, embodiments may include a non-transitory computer-readable medium (CRM) storing software comprising instructions executable by one or more computers which, upon such execution, cause the one or more computers to perform the disclosed methods. Non-transitory CRM may refer to a CRM that stores data for short periods or in the presence of power such as a memory device or Random Access Memory (RAM). For example, a non-transitory computer-readable medium may include storage components, such as, a hard disk (e.g., a magnetic disk, an optical disk, a magneto-optic disk, and/or a solid state disk), a compact disc (CD), a digital versatile disc (DVD), a floppy disk, a cartridge, and/or a magnetic tape. The different parts of the system may be connected using a network (e.g. wireless networks and wired networks). The computer system may include one or more interfaces. The computer system may contain a suitable operating system such as UNIX (RTM), Windows (RTM) or Linux (RTM), for example.

It should be noted that any feature described above may be used with any particular aspect or embodiment of the invention.

### Brief description of the Figures

The present invention may be put into practice in a number of ways and embodiments will now be described by way of example only and with reference to the accompanying drawings, in which:
FIG. 1 shows a front view of a server enclosure, given by way of example only;
FIG. 2 shows a front view of two server enclosures of Figure 1 abutting each other;
FIG. 3 shows a front view of two further server enclosures abutting each other, given by way of example only;
FIG. 4 shows a front view of a plurality of server enclosures installed within a server rack or cabinet;
FIG. 5 shows a top view of the server enclosure of Figure 1 or Figure 2;
   and
FIG. 6 shows a top view of a further example server enclosure.

It should be noted that the figures are illustrated for simplicity and are not necessarily drawn to scale. Like features are provided with the same reference numerals.

### Detailed description of the preferred embodiments

By placing heat conductive materials (forming a heat exchanger) between individual servers, heat transfer is enhanced both through these materials and to adjacent server cooling systems. This approach improves the cooling efficiency, resulting in better performance, longevity of the server hardware, and reduced total cost of ownership (TCO).

In traditional edge liquid-cooled server setups, a heat rejection unit (e.g., a fluid circulator) may be integrated into a server's enclosure. This fluid circulator may be designed to operate independently for each server. While effective, this design can be further enhanced for greater cooling efficiency, especially when servers are experiencing uneven workloads, which can occur often, especially with this type of edge server.

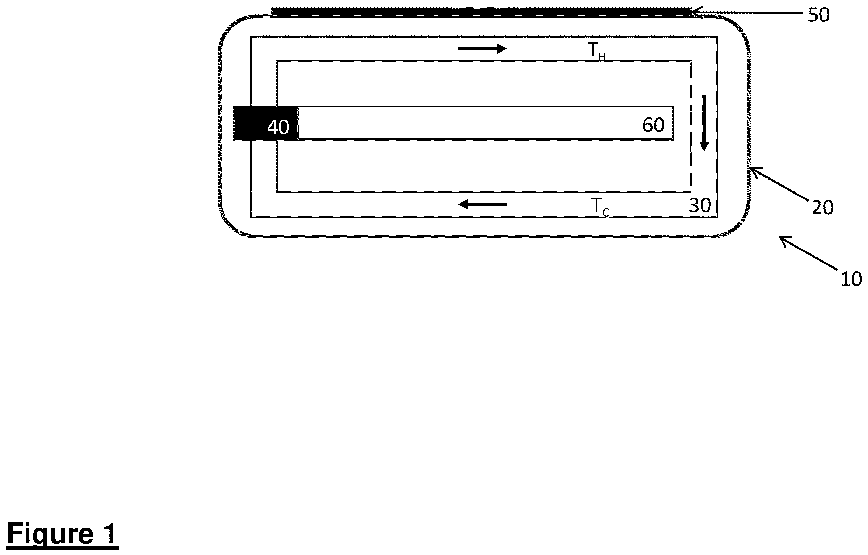

Figure 1 shows a front view of a server enclosure 10. The figures are in schematic form and do not show all details but illustrate features at a high level. The server enclosure comprises a housing 20 (e.g., a metal or sheet housing) that forms the body and external surface of the server enclosure 10. Within the housing 20 is a fluid circulator or liquid cooling circuit 30. Example liquids that may be circulated include water, water/antifreeze mixtures, oil, freon, and other dielectric fluids. The fluid circulator may include a pump (not shown in this figure) or may be gravity driven, with hotter fluid rising and colder fluid falling. The hotter fluid within the fluid circulator 30 is shown as T_{H} and the cooler fluid is shown as T_{C}.

The fluid circulator 30 is thermally coupled (e.g., in contact with) one or more server (electronic) component 40. Pipes or tubes of the fluid circulator 30 may pass over more than one server component 40 but only one is illustrated in this figure. The direction of flow of fluid (cooling fluid) within the fluid circulator 30 is shown by the arrows in this figure. Fluid (dielectric) may also flow within the interior of the house 20.

A heat exchanger 50 is shown close to or in thermal contact with a portion of the fluid circulator 30 containing hotter fluid. When the server 60 is not operating or operating with a low load, all fluid within the fluid circulator 30 may be substantially at the same temperature. However, when the server 60 is operating at a higher load then it may generate substantially more heat from one or more server components 40 (e.g., a CPU). In this case, the heat exchanger 50 may receive heat from the fluid circulator 30 (e.g., directly or through the housing 20). Even when the fluid in a lower load server enclosure has a raised temperature (compared with ambient or no load), it may still act to cool a higher load server.

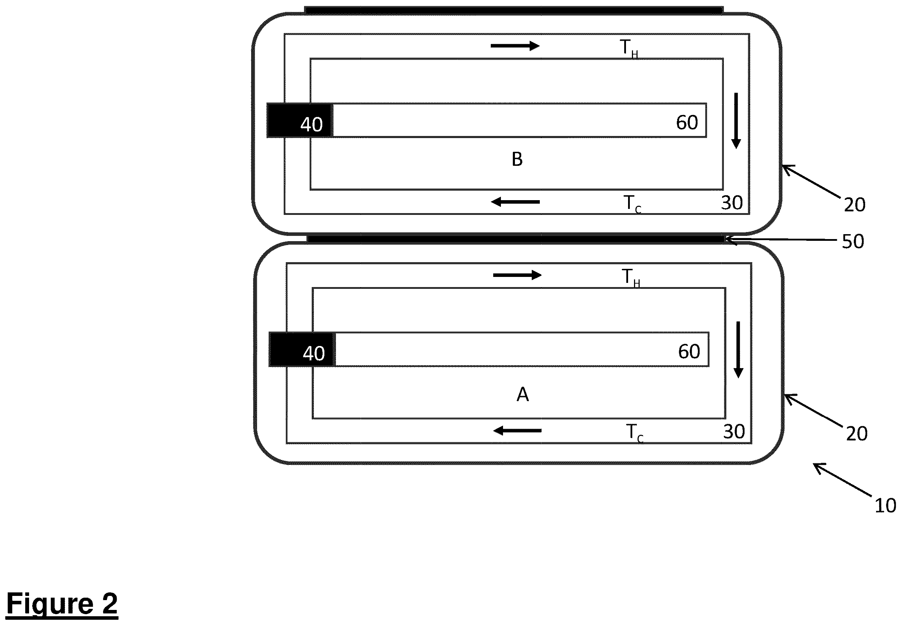

Figure 2 shows a front view of two similar or identical server enclosures 10 (A and B) of Figure 1. In this figure the heat exchanger of server enclosure A is shown below server enclosure B. This figure does not show any other components that hold the server enclosures 10 in position, for simplicity. As described with reference to Figure 1, the heat exchanger 50 of server enclosure A is in thermal contact with the hotter portion of the fluid circulator 30 (at least when the server 60 is operating with server component 40 generating heat). The heat exchanger 50 of server enclosure A is also in thermal contact with server enclosure B and also in thermal contact with the cooler portion of the fluid circulator 30 server enclosure B. Therefore, when the server 60 of server enclosure A is operating and server component 40 is generating heat, this heat may be drawn through the fluid circulator and into the heat exchanger 50 of server enclosure A and then into the fluid circulator 30 of server enclosure B, thereby cooling the fluid flowing through the fluid circulator 30 of server enclosure A. This cooling will be particularly effective when the server 60 of server enclosure B is not operating or operating at a low load (e.g., < 10% of the load of the hotter server 60) because the fluid circulating within the fluid circulator 30 of server enclosure B will be substantially cooler than the fluid circulating within the fluid circulator 30 of server enclosure A. It is important to note that when the server 60 of server enclosure B is operating at a higher load than the server 60 of server enclosure B then heat may flow from the server component(s) 40 of the server 60 of server enclosure B and into the fluid circulator 30 of server enclosure A. Therefore, heat may flow in both directions to provide cooling wherever it is required and when there is an imbalance of server loads.

Server enclosure B also has its own heat exchanger 50 but this is not in contact with another server enclosure in this figure and so does not significantly contribute to any heat flow. The heat exchanger 50 may be formed of a resilient material (e.g., silicone rubber) than is effective in conducting heat and forming a good thermal seal between neighbouring server enclosures 10. Other resilient heat exchanger materials may be used, including greases, silicone grease, metal, foils, rubber, plastics, and foams, for example. The resilient member may take the form or a sheet of thickness 2-10 mm (e.g., around 5mm), for example,

The heat exchanger 50 may take different forms. The heat exchanger 50 may comprise components of the server enclosure 10 formed to transfer heat from one server enclosure 10 to another. For example, the heat exchanger 50 may be formed from a portion of the fluid circulator 30 in thermal contact with an inner portion of the housing 20 (e.g., abutting it for a length of pipe or tube), with a portion of the housing 20 also forming part of the heat exchanger 50. The external surface of the housing 20 may be in thermal contact (either directly or with an intermediate or separating sheet) with an external surface of the housing 20 of another server enclosure 10.

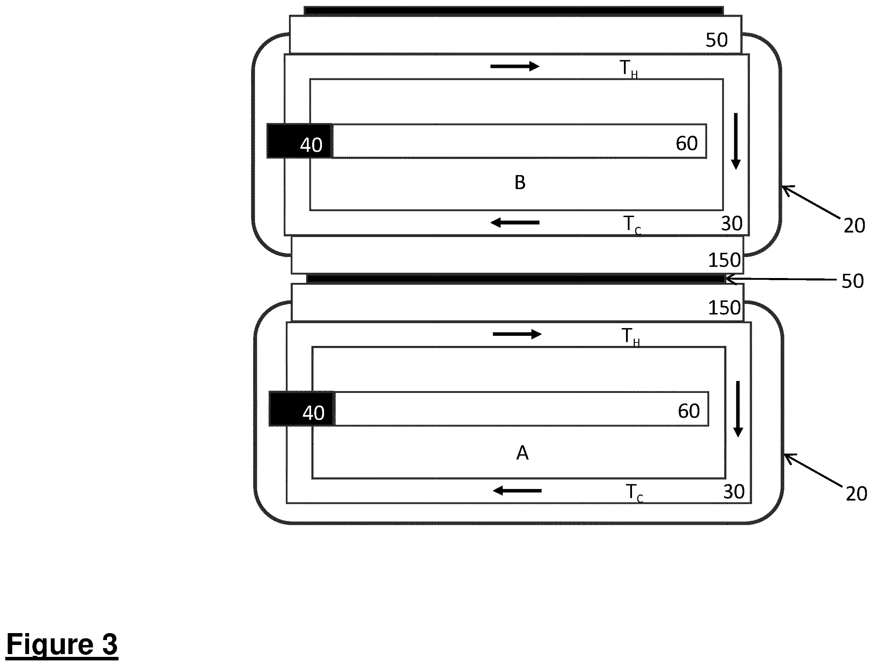

Figure 3 shows a front view of further example server enclosures 10. Similar features and components have the same reference numerals but will not be described again. In this example implementation, the heat exchanger 50 includes one or more further components 150 to increase the effectiveness and efficiency of transferring heat between server enclosures 10. For example, the additional components may include any one or more of: a metal bar or plate, a fluid-filled vessel, a further fluid circulator, and/or another component. Preferably, the further component(s) 150 may form a more direct, more efficient, or closer heat bridge between the fluid circulators 30 of neighbouring or adjacent server enclosures 10.

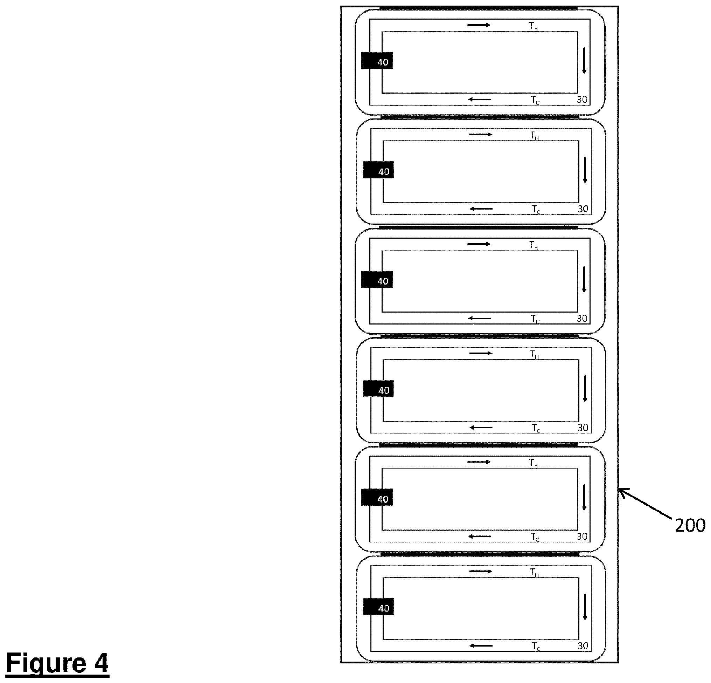

Figure 4 shows a front view of a rack 200, containing a plurality of server enclosures 10. The rack may support any of the server enclosures 10 described with reference to any of Figures 1 to 3. The rack 200 supports each server enclosure 10 and maintains thermal contact between neighbouring or adjacent server enclosures 10 (e.g., by locating them a suitable distance from each other). In this example implementation, server enclosures 10 are shown on top of each other (i.e., relative to a normal interpretation of up and down). The rack 200 may include shelves, drawers, rails, or other components (now shown in this figure) to support the server enclosures 10. The rack may include mechanisms to withdraw or replace each server enclosure 10 to aid maintenance, for example. The rack may also include power supplies and/or cabling for connecting to the server 60 within each server enclosure 10. Preferably, the server enclosures 10 may take the form of a standardised 19 inches (482.6 mm) wide rack mount and the rack 200 can accommodate a plurality of server enclosures.

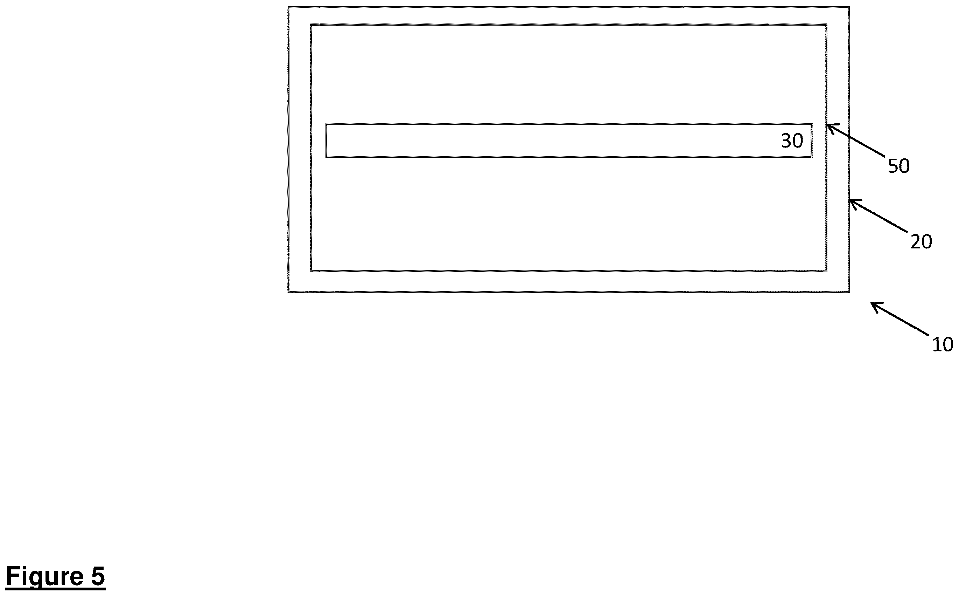

Figure 5 shows a schematic top view of the server enclosure 10 described with reference to any of Figures 1 to 3. This figure illustrates the heat exchanger 50 extending towards an outer edge of the housing 20. However, the heat exchanger 50 may extend to and/or beyond the edge in some example implementations. In one example, the heat exchanger 50 may be the resilient member (e.g., silicone rubber) described above or another form (e.g., as described with reference to Figure 3).

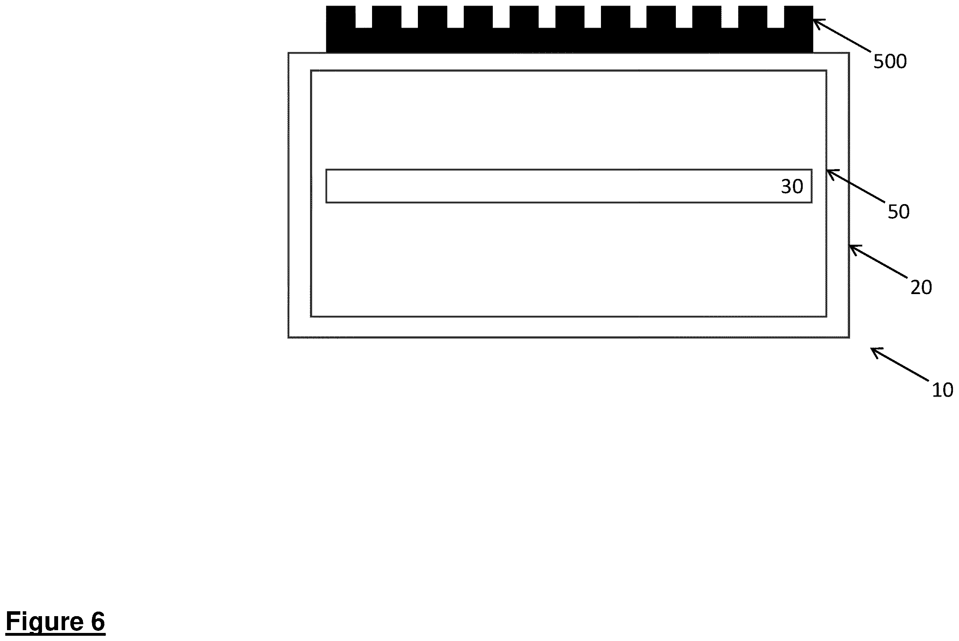

Figure 6 shows a schematic top view of a further example implementation of the server enclosure 10. In this example, one or more heat sinks 500 are shown. The heat sink 500 can further increase the cooling efficiency of the server enclosure 10. The heat sink or heat sinks 500 may be located at a back surface of the housing 20 (i.e., on a surface perpendicular to the heat exchanger 50). The heat sink (or radiator) 500 may include fins or other components to increase its surface area to aid cooling efficiency. The heat sink 500 may be metallic (e.g., aluminium), and/or painted or anodised with a dark colour or black, for example. The heat sink may be in thermal contact with the outer surface of the housing 20 and/or pass through at least a portion of the housing to make contact with a portion of the fluid circulator 30, for example. As well as or instead of the heat sink 500, one or more fans may be configured within the housing 20 to expel air from the interior of the housing and draw in cooler air to further aid cooling. However, the heat sink 500 and fan (not shown in this figure) are optional features.

As used throughout, including in the claims, unless the context indicates otherwise, singular forms of the terms herein are to be construed as including the plural form and vice versa. For instance, unless the context indicates otherwise, a singular reference herein including in the claims, such as "a" or "an" (such as an ion multipole device) means "one or more" (for instance, one or more ion multipole device). Throughout the description and claims of this disclosure, the words "comprise", "including", "having" and "contain" and variations of the words, for example "comprising" and "comprises" or similar, mean "including but not limited to", and are not intended to (and do not) exclude other components. Also, the use of "or" is inclusive, such that the phrase "A or B" is true when "A" is true, "B is true", or both "A" and "B" are true.

The use of any and all examples, or exemplary language ("for instance", "such as", "for example" and like language) provided herein, is intended merely to better illustrate the disclosure and does not indicate a limitation on the scope of the disclosure unless otherwise claimed. No language in the specification should be construed as indicating any non-claimed element as essential to the practice of the disclosure.

The terms "first" and "second" may be reversed without changing the scope of the disclosure. That is, an element termed a "first" element may instead be termed a "second" element and an element termed a "second" element may instead be considered a "first" element.

It is also to be understood that, for any given component or embodiment described throughout, any of the possible candidates or alternatives listed for that component may generally be used individually or in combination with one another, unless implicitly or explicitly understood or stated otherwise. It will be understood that any list of such candidates or alternatives is merely illustrative, not limiting, unless implicitly or explicitly understood or stated otherwise.

Unless otherwise described, all technical and scientific terms used throughout have a meaning as is commonly understood by one of ordinary skill in the art to which the various embodiments described herein belong.

As will be appreciated by the skilled person, details of the above embodiment may be varied without departing from the scope of the present invention, as defined by the appended claims.

For example, whilst the server enclosures in the example implementations are shown on top of each other (with hotter fluid flowing above cooler fluid within the fluid circulators) and the figures and figure descriptions only show stacked topology for the heat exchanger, other orientations may be used. For example, the server enclosures may be in thermal contact next to each other or with their sides in contact. Alternative topologies may include side to side (left to right) or any other tessellating topology, for example. Whilst these may not be optimum for heat conduction, they may be more appropriate in certain installations (e.g., due to space constraints). The server enclosures are shown substantially rectangular but other shapes may be used, provide the heat exchanger can make good thermal contact with another server enclosure 10.

Many combinations, modifications, or alterations to the features of the above embodiments will be readily apparent to the skilled person and are intended to form part of the invention. Any of the features described specifically relating to one embodiment or example may be used in any other embodiment by making the appropriate changes.

## Claims

1. A server enclosure comprising:
a housing having an interior portion configured to receive one or more server components;
a fluid circulator configured to thermally couple to the one or more server components; and
a first heat exchanger thermally coupled to the fluid circulator and configured to be thermally coupled to a second heat exchanger of a second server enclosure.

2. The server enclosure of claim 1 further comprising:
a third heat exchanger thermally coupled to the fluid circulator and configured to be thermally coupled to a fourth heat exchanger of a third server enclosure.

3. The server enclosure of claim 2, wherein the first heat exchanger and the third heat exchanger are located on opposite sides of the housing.

4. The server enclosure according to any previous claim, wherein the first and/or second heat exchanger further comprises:
a resilient member.

5. The server enclosure of claim 4, wherein the resilient member is formed of silicone rubber.

6. The server enclosure according to any previous claim, wherein the fluid circulator is configured to circulate fluid only within the housing.

7. The server enclosure according to any previous claim further comprising a heat sink located on a surface of the housing perpendicular to the first heat exchanger.

8. The server enclosure of claim 7, wherein the heat sink is thermally coupled to the fluid circulator.

9. The server enclosure according to any previous claim further comprising a fan configured to drive air from the interior portion of the housing.

10. The server enclosure according to any previous claim, wherein the one or more server components form at least a part of a radio access network, RAN, edge server.

11. The server enclosure according to any previous claim, wherein the fluid circulator further comprises a pump configured to circulate fluid.

12. The server enclosure according to any previous claim further comprising a heater within the fluid circulator.

13. A system comprising:
a rack configured to support a first server enclosure and a second server enclosure according to any previous claim, wherein the rack is further configured to locate the first heat exchanger of the first server enclosure abutting the second heat exchanger of the second server enclosure.

14. The system of claim 13, wherein the system is a base station of a telecommunications network.

15. The system of claim 13 or claim 14, wherein the fluid circulator of the first server enclosure forms a separate fluid circuit to the fluid circulator of the second server.
